(19) **Europäisches Patentamt European Patent Office Office européen des brevets**

(11) **EP 1 658 509 B1**

(12) **FASCICULE DE BREVET EUROPEEN**

(45) Date de publication et mention de la délivrance du brevet:
**14.02.2007 Bulletin 2007/07**

(21) Numéro de dépôt: **04786347.7**

(22) Date de dépôt: **24.08.2004**

(51) Int Cl.:
*G01R 19/155* (2006.01)        *G01R 19/165* (2006.01)
*H05C 1/04* (2006.01)          *G08B 13/12* (2006.01)
*G08B 13/26* (2006.01)         *G01R 31/08* (2006.01)

(86) Numéro de dépôt international:
**PCT/FR2004/002183**

(87) Numéro de publication internationale:
**WO 2005/022174 (10.03.2005 Gazette 2005/10)**

(54) **SYSTEME DE DETECTION ET DE LOCALISATION DE DEFAILLANCES DANS UNE CLOTURE ELECTRIFIEE**

SYSTEM ZUM ERKENNEN UND FINDEN VON FEHLERN IN EINEM ELEKTRISCHEN ZAUN

SYSTEM FOR DETECTING AND LOCATING FAULTS IN AN ELECTRIC FENCE

(84) Etats contractants désignés:
**AT BE BG CH CY CZ DE DK EE ES FI FR GB GR HU IE IT LI LU MC NL PL PT RO SE SI SK TR**
Etats d'extension désignés:
**AL HR LT LV MK**

(30) Priorité: **27.08.2003 FR 0310210**

(43) Date de publication de la demande:
**24.05.2006 Bulletin 2006/21**

(73) Titulaire: **Martec Serpe-Iesm**
**56520 Guidel (FR)**

(72) Inventeurs:
• **JUTEL, Dominique**
  **F-29300 Quimperle (FR)**

• **PERROT, Yvon**
  **F-56270 Ploemeur (FR)**

(74) Mandataire: **Bentz, Jean-Paul**
**Cabinet Ballot**
**4 rue du Général Hoche**
**BP 855**
**56100 Lorient (FR)**

(56) Documents cités:
EP-A- 0 179 435          FR-A- 2 458 078
FR-A- 2 654 239          FR-A- 2 673 020
GB-A- 2 069 206          GB-A- 2 155 224
US-A- 4 523 187

**Description**

L'invention porte de façon générale sur les clôtures électrifiées, et en particulier sur les systèmes de détection de défaillances dans une clôture électrifiée. De tels systèmes sont notamment utilisés pour détecter et signaler une intrusion au niveau des fils de clôtures électrifiés. Ces clôtures comprennent typiquement des fils métalliques à nu sur lesquels sont appliquées des impulsions de tension pour faire subir un choc électrique à une personne touchant ces fils. La période et le niveau de ces impulsions sont notamment définis dans la norme EN61011.

Le document FR-A-2 673 020 décrit un système de protection anti-intrusion d'une clôture. Ce système comprend un fil de ligne formant une boucle entre les bornes d'un électrificateur comportant un générateur d'impulsions de haute tension et un générateur de signaux sinusoïdaux basse tension de détection d'intrusion. Les signaux de détection sont émis pendant l'intervalle séparant deux impulsions de haute tension. Le fil de ligne est connecté à des composants électriques pour former un circuit résonant. Le système détecte les variations de la capacité du fil de clôture à l'aide d'une boucle d'asservissement de phase et détermine une intrusion ou une défaillance lorsque cette phase est modifiée.

Le document EP-A-0179435 décrit un autre système de protection anti-intrusion d'une clôture comprenant un système de détection de défaillances dans une clôture électrifiée basé sur l'application d'impulsions, la mesure de tension et la comparaison avec une valeur de référence.

Afin de déterminer la zone d'une intrusion, il est usuel de disposer plusieurs systèmes de détection consécutifs associés à de courts tronçons de fils de clôture. La zone d'intrusion est déterminée par l'identification du système ayant détecté l'intrusion. Ces systèmes présentent soit une précision de localisation insuffisante, soit la longueur de fil de clôture associée à un système est très réduite. Ainsi, pour garder une bonne précision de localisation pour un périmètre de clôture donné, il est nécessaire d'utiliser un grand nombre de systèmes de détection, ce qui rend le coût et le temps d'installation de la clôture élevés.

Ces différents systèmes sont également incapables de déterminer le type de défaillance subi par la clôture. Lors d'une détection de défaillance, une coupure n'est ainsi pas différenciée d'un court-circuit au niveau du fil de clôture. La localisation de la défaillance est en outre insuffisante.

L'invention porte ainsi sur un système visant à résoudre un ou plusieurs de ces inconvénients. L'invention porte ainsi sur un système de détection de défaillances dans une clôture électrifiée, comprenant:

- un condensateur présentant une première borne et une deuxième borne susceptible de connecter le condensateur en série à un fil de clôture conducteur;
- un générateur appliquant des impulsions de haute tension sur une des bornes du condensateur à des intervalles prédéterminés, les impulsions étant adéquates pour produire un choc électrique à une personne touchant le fil;
- un générateur de signaux sinusoïdaux de détection de défaillance, appliquant ces signaux sinusoïdaux sur la première borne du condensateur au moins partiellement durant l'intervalle entre les impulsions;
- un dispositif de mesure, mesurant les tensions aux bornes du condensateur pendant l'application des signaux sinusoïdaux;
- un dispositif de traitement des tensions mesurées, déterminant si une éventuelle défaillance est un court-circuit ou une coupure sur le fil connecté, déterminant également la distance entre le condensateur et une défaillance.

Selon une autre variante, le système comprend un fil de clôture conducteur isolé de la terre entre ses deux extrémités et dont une première extrémité est connectée à la deuxième borne du condensateur.

Selon encore une variante, le système comprend un troisième condensateur, connecté entre la deuxième extrémité du fil et la terre.

On peut également prévoir un système qui comprend en outre un deuxième condensateur disposé à proximité de l'autre condensateur et présentant une première borne connectée à la première borne de l'autre condensateur, et une deuxième borne connectée à la deuxième extrémité du fil conducteur, et dans lequel le fil s'étend en au moins deux brins sensiblement parallèles. Le dispositif de mesure peut alors mesurer la tension de la deuxième borne du deuxième condensateur, et le dispositif de traitement détermine le type de défaillance et la distance entre les condensateurs et la défaillance à partir des tensions des deuxièmes bornes déterminées.

Selon une variante, le système comprend un troisième condensateur, connecté entre le milieu du fil et la terre.

Selon une autre variante, le dispositif de traitement compare la tension à la deuxième borne à un seuil supérieur d'une plage normale et à un seuil inférieur de la plage normale, le dispositif de traitement déterminant un court-circuit sur le fil lorsque la tension à la deuxième borne est inférieure au seuil inférieur et le dispositif déterminant une coupure sur le fil lorsque la tension à la deuxième borne est supérieure au seuil supérieur.

Selon encore une variante, le dispositif de traitement comprend une interface d'acquisition de propriétés électriques du fil et une mémoire susceptible de mémoriser les propriétés électriques acquises. Selon encore une autre variante, le fil de clôture forme une double boucle. On peut prévoir que la double boucle est fermée. Selon une variante, les brins du fil de clôture s'étendent dans des directions opposées depuis chaque extrémité.

On peut également prévoir un groupe de systèmes dans lequel chaque système présente au moins deux autres condensateurs connectés à un autre fil de clôture de façon similaire auxdits premier et deuxième condensateurs, un boîtier dans lequel sont inclus le dispositif de mesure et le dispositif de traitement respectif de chaque système, les boîtiers étant accolés.

Un système de surveillance peut comprendre un tel groupe et un dispositif de contrôle communiquant avec le dispositif de traitement de chaque système du groupe pour détecter et signaler le type de défaillance communiqué le cas échéant par chaque dispositif de traitement.

D'autres particularités et avantages de l'invention apparaîtront clairement à la lecture de la description suivante qui est donnée à titre d'exemple non limitatif et en regard des figures. Ces figures montrent:

- Figure 1, un schéma électrique de principe d'une première variante de l'invention;
- Figure 2, un schéma électrique de principe d'une deuxième variante de l'invention;
- Figures 3 et 4, des schémas de systèmes mis en place.

L'invention propose ainsi un système de détection et de localisation de défaillances dans une clôture électrifiée. Le système comprend un condensateur à connecter en série à un fil de clôture conducteur. Un générateur applique à ce condensateur des impulsions de dissuasion et une tension sinusoïdale de détection. Un dispositif de mesure lit les tensions aux bornes du condensateur pendant l'application de la tension de détection, puis un dispositif de traitement de ces tensions détermine le type de défaillance, puis la distance entre la première borne et une défaillance. Cette distance correspond à la longueur du fil entre le condensateur et la défaillance lorsque le fil est déployé. Le système fonctionne ainsi comme un diviseur capacitif ou résistif pour déterminer cette distance.

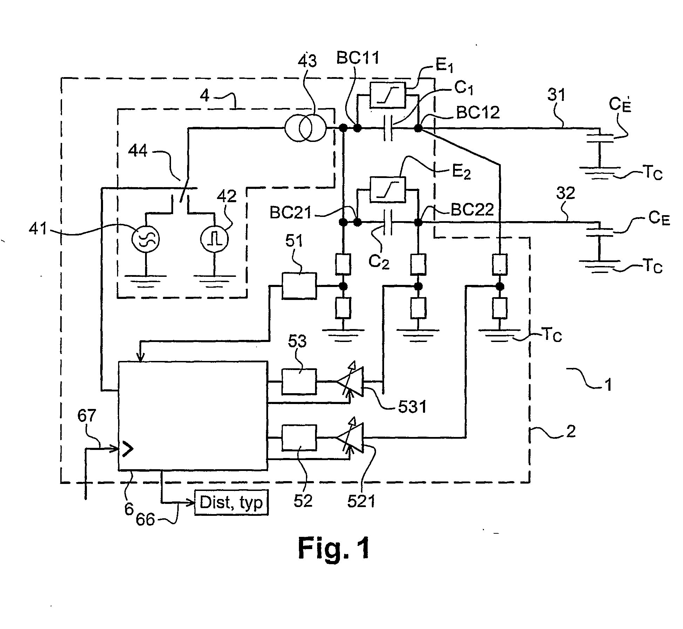

La figure 1 illustre une première variante de système de détection 1 selon l'invention. Le système de détection est en l'occurrence formé sous forme d'un module 2 destiné à être connecté à un ou plusieurs fils de clôture électrique. Les fils de clôture peuvent cependant faire partie intégrante du système. Le système 1 comprend notamment au moins un condensateur C1 présentant une première borne BC11 et une deuxième borne BC12 susceptible de connecter le condensateur C1 en série à un fil de clôture conducteur 31.

Un générateur 4 applique des impulsions de haute tension sur la borne BC11 du condensateur C1 à des intervalles prédéterminés. Les impulsions sont adéquates pour produire un choc électrique à une personne touchant le fil 31. L'homme de métier trouvera les niveaux de tension et les rapports cycliques des impulsions dans les normes correspondantes.

Le générateur 4 génère également des signaux sinusoïdaux de détection de défaillance et applique ces signaux sinusoïdaux sur la borne BC11 au moins partiellement durant l'intervalle entre les impulsions.

Un dispositif de mesure comprend les voltmètres 51 et 52. Ce dispositif de mesure mesure les tensions aux bornes du condensateur C1 pendant l'application des signaux sinusoïdaux. Le voltmètre 51 récupère ainsi la tension de la borne BC11 par l'intermédiaire d'un diviseur de tension. Le voltmètre 52 récupère la tension de la borne BC12 également par l'intermédiaire d'un diviseur de tension. Ces voltmètres mesurent par exemple une image de la tension efficace aux bornes du condensateur C1.

Le système comprend également un dispositif de traitement 6, récupérant les tensions mesurées et traitant ces tensions pour déterminer le type de défaillance et la distance entre le condensateur C1 et une éventuelle défaillance. La distance séparant les bornes du condensateur C1 est suffisamment négligeable par rapport aux dimensions des fils de clôture utilisées.

Le système comprend ou est connecté à un fil de clôture conducteur 31. Une extrémité de ce fil conducteur est connectée à la borne BC12 du condensateur C1. Le fil de clôture 31 est isolé de la terre entre ses deux extrémités. Ainsi, la mise à la terre ou une coupure du fil entre une de ses extrémités changera l'état électrique vu par le système.

Le dispositif de traitement 6 présente une première fonction de détermination du type de défaillance et une deuxième fonction de localisation de cette défaillance. Pour déterminer le type de défaillance, le dispositif de traitement 6 détermine si la tension de la borne BC12 sort d'une plage de valeurs considérées comme normales. Si la tension de BC12 franchit le seuil inférieur de la plage, le dispositif de traitement 6 détermine la présence d'un court-circuit. Si la tension de BC12 franchit le seuil supérieur de la plage, le dispositif de traitement 6 détermine la présence d'une coupure du fil 31. La tension de BC12 (ou une image de cette tension) peut pour cela être appliquée à l'entrée de deux comparateurs recevant respectivement en entrée les tensions seuil de la plage de valeur.

Lorsque le dispositif 6 a déterminé la présence d'une défaillance et son type, il réalise un traitement adéquat pour déterminer la localisation de la défaillance sur le fil de clôture 31.

Ce traitement va maintenant être détaillé pour la variante de la figure 1, un condensateur $C_E$ est connecté entre la deuxième extrémité du fil et la terre clôture $T_c$.

Lorsque le fil 31 est coupé en un point, le fil se comporte comme un condensateur relié à la terre par ce point et relié au condensateur C1 par sa première extrémité. La capacité $C_{FC}$ de ce condensateur est définie par la distance entre le condensateur C1 et le point de coupure, ainsi que par la capacité linéique du fil.

La distance entre le condensateur C1 et le point de coupure est ainsi déterminée par la formule suivante:

$$d = D * \frac{C_{FC}}{C_{FT}} = \frac{D}{C_{FT}} * (C_1 * ((V_{BC11}/V_{BC12}) - 1))$$

$C_1$ désignant la capacité du condensateur $C_1$, $C_{FC}$ la capacité du fil coupé, $C_{FT}$ la capacité du fil non coupé, D la longueur initiale du fil, $V_{BC11}$ et $V_{BC12}$ les tensions respectives des bornes BC11 et BC12.

Le dispositif de traitement 6 peut ainsi déterminer avec une grande précision la distance entre le condensateur C1 et la coupure.

En cas de court-circuit à la terre, par exemple lorsqu'un élément sectionne le fil et le connecte à la terre en un point, la distance entre le point de court-circuit et le condensateur C1 peut être déterminée par la formule suivante, en se basant sur la résistance linéaire du fil et en négligeant sa capacité linéique:

$$d = D * r/R = \frac{V_{BC12}}{V_{BC11}} * \frac{1}{R * C_1 * \omega * (1 - V_{BC12}/V_{BC11})}$$

R désignant la résistance initiale du fil et $\omega$ la pulsation de la tension sinusoïdale de détection. On utilisera une capacité du fil et une fréquence du signal de détection adéquates pour que l'impédance capacitive du fil soit nettement supérieure à la résistance du fil. Cette capacité est donc négligée dans le calcul qui précède. Pour un fil d'une longueur de 5000 mètres et un signal de détection à une fréquence de 100 Hz, on obtient ainsi typiquement une impédance capacitive du fil d'environ 40 Kiloohms alors que la résistance du fil est de l'ordre de 750 ohms.

On peut ainsi générer des signaux différents en fonction du type de défaillance détecté. La signalisation de la défaillance est réalisée par tout moyen approprié. Elle peut notamment comprendre l'affichage du type de défaillance, de la distance de cette défaillance ou l'identification du fil sur lequel a lieu la défaillance sur un écran du système. La signalisation peut également comprendre un avertissement sonore de défaillance. Le dispositif de traitement peut également présenter une interface de sortie adéquate pour communiquer ces informations à un dispositif de supervision ou de surveillance 8, un terminal de communication portable ou similaire. On peut notamment envisager une liaison série locale (par exemple RS232, USB ou Ird), une liaison distante multi-points (par exemple RS485) ou éventuellement une liaison radio (par exemple Blutooth ou Wifi).

Dans la variante de la figure 1, le condensateur CE est connecté entre la deuxième extrémité du fil et la terre. Cette deuxième extrémité peut en particulier être supportée par un poteau et être connectée à la terre clôture $T_c$. La terre clôture $T_c$ est au même potentiel que la terre. Cette variante permet de déterminer une défaillance et sa position avec un fil de clôture de longueur importante pour une précision de détermination donnée. La variante de la figure 1 peut être adaptée afin de réaliser une détection par un même système sur un ou plusieurs autres fils de clôture, par exemple des fils de clôture parallèles au fil 31. Un deuxième condensateur C2 est connecté par la borne BC21 à la borne BC11. Ces deux bornes sont donc alimentées et mesurées identiquement. La borne BC22 du condensateur C2 est connectée à une extrémité du fil de clôture 32. Un condensateur CE est également connecté entre la deuxième extrémité du fil 32 et la terre clôture.

Bien qu'on ait représenté sur la figure 1 un unique fil de clôture supplémentaire 32, on peut accoler de façon similaire d'autres fils de clôture superposés verticalement pour augmenter la hauteur ou la densité de la clôture. Le voltmètre 53 récupère la tension de la borne BC22 également par l'intermédiaire d'un diviseur de tension. Avec un nombre réduit d'éléments supplémentaires, le dispositif de mesure mesure ainsi également les tensions aux bornes du condensateur C2. La détection de défaillance et la détermination de la distance peuvent être réalisées comme décrit ci-dessus.

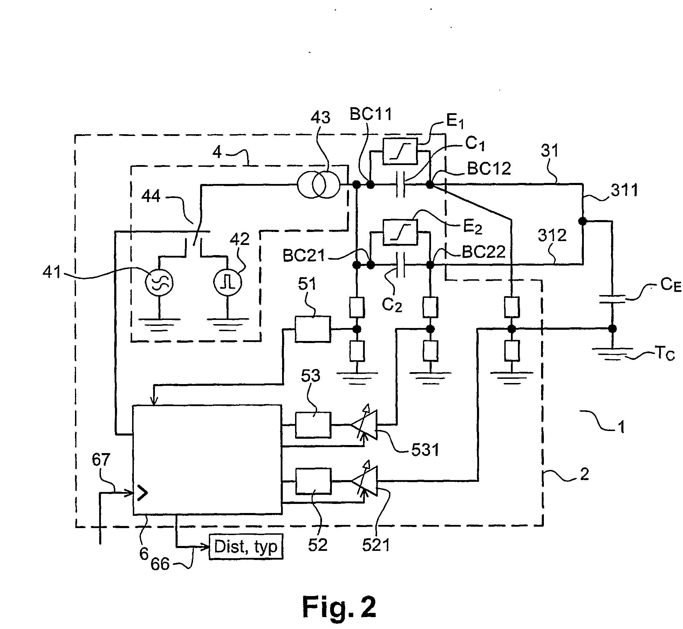

La figure 2 illustre une deuxième variante de l'invention. Cette variante propose d'utiliser un fil 31 formant plusieurs brins parallèles, et de connecter un second condensateur C2 à la deuxième extrémité du fil. Le condensateur C2 présente ainsi une première borne BC21 au même potentiel que la borne BC11. La deuxième borne BC22 est connectée à la deuxième extrémité du fil. Le fil 31 présente deux brins parallèles 311 et 312.

Comme illustré le dispositif de mesure mesure la tension de la borne BC22 par l'intermédiaire du voltmètre 53. Cette mesure est traitée par le dispositif 6 pour déterminer la distance entre la défaillance et le condensateur C2. Un traitement similaire à celui décrit pour la variante de la figure 1 peut être réalisé pour déterminer le type de défaillance, et la distance entre la défaillance et les condensateurs C1 et C2. Cette alternative permet d'augmenter la précision de la localisation de la défaillance, en croisant les distances déterminées à partir des mesures effectuées sur les condensateurs C1 et C2. Dans l'hypothèse où le fil 31 ne présente aucune connexion entre ses deux extrémités, les formules données précédemment peuvent être utilisées pour déterminer la distance (la longueur de fil) entre la défaillance et chaque condensateur (Pour le condensateur C2, il faut remplacer la valeur $C_1$ par la capacité du condensateur C2 et remplacer la tension $V_{BC12}$ par la tension $V_{BC22}$. Les tensions mesurées pour les deuxièmes bornes des condensateurs C1 et C2 étant inversement proportionnelles, le dispositif de traitement déduit également sur quel brin a lieu la défaillance.

Le fil 31 peut bien entendu former plus de deux brins parallèles entre les condensateurs C1 et C2.

Le système de la figure 2 comprend en outre un condensateur CE connectant le milieu du fil 31 à la terre. Même si la défaillance a lieu à mi-longueur du fil 31, elle a lieu d'un côté ou de l'autre de la connexion du condensateur CE. Il y aura donc toujours un déséquilibre entre les deux brins du fil 31 en cas de défaillance. Le dispositif de traitement 6 peut donc déterminer une défaillance située au niveau du milieu du fil. Les formules de détermination de distance précédentes peuvent être adaptées à ce cas particulier. Par exemple, pour une coupure, on peut déterminer dans un premier temps sur quel brin a lieu la défaillance avec les seuils définis auparavant, puis utiliser la formule suivante pour le brin coupé:

$$d = D * \frac{C_{FC}}{C_{FT}} = \frac{D}{C_{FT}} * (C * ((V_{BC1}/V_{BC2}) - 1))$$

et la formule suivante pour le brin déterminé non coupé:

$$d = D * \frac{C_{FC}}{C_{FT}} = \frac{D}{C_{FT}} * (C * ((V_{BC1}/V_{BC2}) - 1) - C_E)$$

$V_{BC1}$ étant la tension sur la première borne, $V_{BC2}$ la tension sur la deuxième borne et C, $C_E$ les capacités respectives du condensateur connecté à l'extrémité du brin et du condensateur connecté au milieu du fil.

On va maintenant détailler des variantes supplémentaires de l'invention, disponibles dans les exemples des figures 1 et 2.

Le générateur 4 comprend un générateur du signal basse tension 41 et un générateur d'impulsions 42. Le générateur 4 comprend aussi un commutateur 44 appliquant sélectivement la tension des générateurs 41 et 42 sur le primaire d'un transformateur 43. Le secondaire du transformateur 43 applique ainsi la tension souhaitée sur la borne BC11 du condensateur C1. Le commutateur 44 peut par exemple être commandé par un signal d'horloge ou par le dispositif 6.

Le signal basse tension présente par exemple une fréquence comprise entre 100 et 50000 Hz. L'homme de métier saura déterminer la fréquence adéquate en fonction de la longueur de fil de clôture connectée au premier condensateur. Le signal peut être émis sous forme de trains d'ondes avec un rapport cyclique inférieur ou égal à 0,95. La fréquence des impulsions étant généralement de l'ordre de 1 seconde, un tel rapport cyclique est suffisant pour assurer une détection d'intrusion, tout en garantissant une détection pendant 95 % du temps.

Le commutateur 44 comprend préférentiellement des transistors et des composants d'électronique de puissance pour la commutation de la tension appliquée sur le primaire du transformateur 43. Un tel commutateur est plus fiable qu'un commutateur électromécanique.

Les condensateurs aux bornes desquels la tension est mesurée présentent de préférence un dispositif écréteur de tension connecté en parallèle à leurs bornes. Des écréteurs sont identifiés sur les figures 1 et 2 par les références E1 et E2. De tels dispositifs écréteurs, connus en soi, protégent les condensateurs lors de l'application des impulsions haute tension, en court-circuitant les condensateurs lorsque la tension à leur borne atteint un niveau prédéterminé.

Le dispositif de traitement 6 dispose d'une entrée 67 sur laquelle est appliquée un signal de synchronisation ou un signal de commande. Cette entrée permet au dispositif 6 de n'effectuer le traitement que durant les intervalles séparant deux impulsions de dissuasion. Le traitement des tensions mesurées n'est ainsi pas faussé.

Des amplificateurs à gain variable 521 et 531 sont avantageusement utilisés pour modifier le niveau de tension des bornes respectives BC12 et BC22 fourni au dispositif de traitement 6. Le dispositif de traitement 6 dispose alors d'un niveau de tension optimal pour la précision de la détermination de distance de la défaillance. Ces amplificateurs à gain variable 521 et 531 sont particulièrement utiles lorsque la défaillance est un court-circuit car le niveau de tension mesuré est alors relativement bas. Avec les amplificateurs à gain variable, la détermination de la distance de la défaillance se fait alors en deux étapes, comme détaillé auparavant: une première étape de détermination du type de défaillance et une deuxième étape de localisation de la défaillance. Durant la première étape, la tension de la deuxième borne d'un condensateur est amplifiée avec un gain prédéterminé, mesurée par le dispositif de mesure, puis la valeur de la tension amplifiée est fournie au dispositif de traitement 6. Cette valeur est comparée aux seuils de court-circuit et de coupure comme détaillé auparavant, afin de déterminer le type de défaillance éventuellement subi. Le niveau de tension mesuré est donc fonction de la défaillance. La précision de la localisation n'est donc pas identique pour les deux types de défaillance. Lors de la deuxième étape, le dispositif de traitement 6 modifie la valeur du gain d'amplification en fonction du type de défaillance. Pour une coupure, on pourrait éventuellement diminuer le gain à une valeur prédéterminée. Pour un court-circuit, on augmente le gain à une autre valeur prédéterminée. Les gains sont choisis de sorte que le dispositif de traitement ait une précision de calcul maximale pour la valeur fournie par le dispositif de mesure.

On peut prévoir un dispositif de traitement 6 traitant des mesures numériques ou analogiques. Le dispositif 6 peut notamment présenter, de façon connue en soi, des convertisseurs analogique/numérique sur son interface d'entrée pour effectuer des traitements sur des signaux numériques.

On peut prévoir que les caractéristiques du ou des fils ainsi que la configuration de connexion entre les fils et les condensateurs soit mémorisée dans le système. On peut notamment prévoir de mémoriser la résistance ou la capacité linéique des fils, leur longueur ou tout autre paramètre de la clôture (par exemple des abaques obtenus par des essais sur la clôture) devant être adapté pour réaliser le traitement. Le système peut notamment présenter une interface pour l'inscription manuelle de ces informations ou un dispositif de mesure des caractéristiques des fils de clôture connectés pour déterminer automatiquement ces informations.

On peut également réaliser une alternance de fils alimentés et de fils non alimentés dans la clôture. On peut ainsi augmenter la densité de fils de clôture. Les impulsions sont en outre plus efficaces dans le cas où un intrus touche simultanément un fil alimenté et un fil non alimenté. L'homme de métier sait déterminer le nombre de poteaux nécessaires pour supporter les fils en fonction de leur longueur.

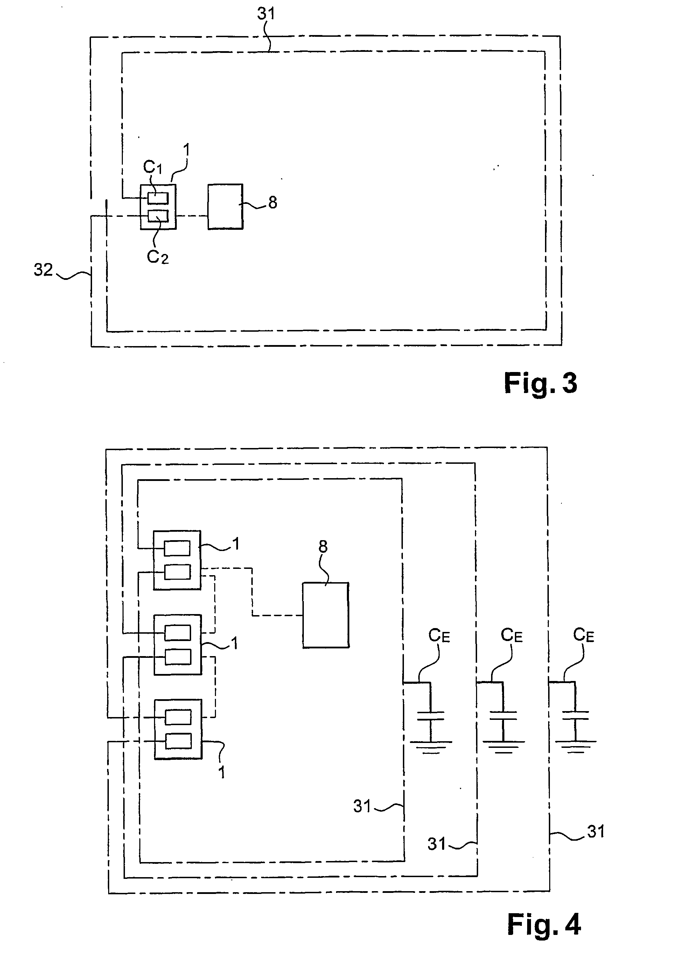

La figure 3 illustre un exemple de mise en oeuvre de tels systèmes. Les fils de clôture 31 et 32 forment ainsi une zone fermée. En l'occurrence, les fils de clôture 31 et 32 s'étendent dans des directions opposées depuis chaque extrémité de fil pour former une clôture.

La figure 4 illustre un exemple d'utilisation d'un groupe de systèmes selon la deuxième variante pour former une clôture fermée. Dans cet exemple, chaque système comprend un boîtier incluant son dispositif de mesure et son dispositif de traitement. Les boîtiers sont accolés de sorte que la longueur du câblage est réduite. Le coût d'installation est ainsi également réduit. Chaque système comprend deux condensateurs supplémentaires connectés à un fil supplémentaire, de façon similaire aux condensateurs C1, C2 avec le fil 31. Les fils des différents systèmes sont superposés.

Ce groupe de systèmes peut communiquer avec le dispositif 8 ayant une fonction de contrôle de surveillance ou de supervision. Le dispositif de traitement de chaque système communique avec le dispositif 8 pour que celui-ci puisse détecter le type de défaillance et sa position, et signaler ces informations à un utilisateur.

Cette mise en place peut également être réalisée en distribuant les boîtiers en différents points de la zone à surveiller.

L'invention n'est bien entendu pas limitée aux exemples représentés et décrits. Ainsi, bien qu'on ait représenté des systèmes présentant un ou deux fils de clôture, l'invention s'applique également à un système présentant un nombre important de fils de clôture superposés, couvrant par exemple une hauteur importante avec un maillage serré.

## Revendications

1. Système de détection de défaillances (1) dans une clôture électrifiée, comprenant:

   - un condensateur (C1) présentant une première borne (BC11) et une deuxième borne (BC12) susceptible de connecter le condensateur en série à un fil de clôture conducteur (31);
   - un générateur (42) appliquant des impulsions de haute tension sur une des bornes du condensateur à des intervalles prédéterminés, les impulsions étant adéquates pour produire un choc électrique à une personne touchant le fil;
   - un générateur (41) de signaux sinusoïdaux de détection de défaillance, appliquant ces signaux sinusoïdaux sur la première borne (BC11) du condensateur au moins partiellement durant l'intervalle entre les impulsions;
   - un dispositif de mesure, mesurant les tensions aux bornes du condensateur (C1) pendant l'application des signaux sinusoïdaux;
   - un dispositif de traitement (6) des tensions mesurées, déterminant si une éventuelle défaillance est un court-circuit ou une coupure sur le fil connecté, puis déterminant la distance entre le condensateur (C1) et une défaillance.

2. Système selon la revendication 1, **caractérisé en ce qu'**il comprend un fil de clôture conducteur (31) isolé de la terre entre ses deux extrémités et dont une première extrémité est connectée à la deuxième borne du condensateur (BC12).

3. Système selon la revendication 2, **caractérisé en ce qu'**il comprend un troisième condensateur (CE), connecté entre la deuxième extrémité du fil et la terre.

4. Système selon la revendication 2, **caractérisé en ce que** :

- il comprend en outre un deuxième condensateur (C2) disposé à proximité de l'autre condensateur et présentant une première borne (BC21) connectée à la première borne de l'autre condensateur (C1), et une deuxième borne connectée à la deuxième extrémité du fil conducteur;
- le fil s'étend en au moins deux brins (311, 312) sensiblement parallèles.

5. Système selon la revendication 4, **caractérisé en ce que** le dispositif de mesure (6) mesure la tension de la deuxième borne du deuxième condensateur, et **en ce que** le dispositif de traitement détermine, le type de défaillance et la distance entre les condensateurs et la défaillance à partir des tensions des deuxièmes bornes déterminées.

6. Système selon la revendication 4 ou 5, **caractérisé en ce qu'**il comprend un troisième condensateur (CE), connecté entre le milieu du fil et la terre.

7. Système selon l'une quelconque des revendications précédentes, **caractérisé en ce que** le dispositif de traitement compare la tension à la deuxième borne à un seuil supérieur d'une plage normale et à un seuil inférieur de la plage normale, le dispositif de traitement déterminant un court-circuit sur le fil lorsque la tension à la deuxième borne est inférieure au seuil inférieur et le dispositif déterminant une coupure sur le fil lorsque la tension à la deuxième borne est supérieure au seuil supérieur.

8. Système selon l'une quelconque des revendications 2 à 7, **caractérisé en ce que** le dispositif de traitement comprend une interface d'acquisition de propriétés électriques du fil et une mémoire susceptible de mémoriser les propriétés électriques acquises.

9. Système selon l'une quelconque des revendications 4 à 8, **caractérisé en ce que** le fil de clôture forme une double boucle.

10. Système selon la revendication 9, **caractérisé en ce que** la double boucle est fermée.

11. Système selon la revendication 9 ou 10, **caractérisé en ce que** les brins du fil de clôture s'étendent dans des directions opposées depuis chaque extrémité.

12. Groupe de systèmes selon l'une quelconque des revendications 4 à 8, **caractérisé en ce que** chaque système présente au moins deux autres condensateurs connectés à un autre fil de clôture de façon similaire auxdits premier et deuxième condensateurs, un boîtier dans lequel sont inclus le dispositif de mesure et le dispositif de traitement respectif de chaque système, aussi **caractérisé en ce que** les boîtiers sont accolés.

13. Système de surveillance comprenant :

- le groupe de la revendication 12; et
- un dispositif de contrôle (8) communiquant avec le dispositif de traitement de chaque système du groupe pour détecter et signaler le type de défaillance communiqué le cas échéant par chaque dispositif de traitement.

**Claims**

1. A system for the detection of malfunctions (1) in an electrified fence comprising:

- a capacitor (C1) having a first terminal (BC11) and a second terminal (BC12) capable of series-connecting the capacitor with a conductive fencing wire (31) ;
- a generator (42) applying high-voltage impulses to one of the terminals of the capacitor at predetermined intervals the impulses being sufficient to produce an electric shock in a person touching the wire;
- a generator (41) of malfunction-detecting sine signals applying these sine signals to the first terminal (BC11) of the capacitor at least partially during the interval between the impulses;
- a measurement device measuring the voltages at the terminals of the capacitor (C1) during the application of the sine signals;
- a device (6) for processing measured voltages, determining whether a malfunction, if any, is a short-circuit or a cut in the connected wire, and then determining the distance between the capacitor (C1) and a malfunction.

2. A system according to claim 1, **characterized in that** it comprises a conductive fencing wire (31) insulated from ground between its two ends and having a first end connected to the second terminal of the capacitor (BC12).

3. A system according to claim 2, **characterized in that** it comprises a third capacitor (CE), connected between the second end of the wire and ground.

4. A system according to claim 2, **characterized in that** :

- it furthermore comprises a second capacitor (C2) positioned in the vicinity of the other capacitor and having a first terminal (BC21) connected to the first terminal of the other capacitor (C1) and a second terminal connected to the second end of the conductive wire,
- the wire extending in at least two substantially parallel strands (311, 312).

5. A system according to claim 4, **characterized in that** the measurement device (6) measures the voltage of the second terminal of the second capacitor, and the processing device determines the type of malfunction and the distance between the capacitors and the malfunction by means of the voltages of the second terminals determined.

6. A system according to claim 4 or 5, **characterized in that** it comprises a third capacitor (CE), connected between the midpoint of the wire and ground.

7. A system according to any of the above claims, **characterized in that** the device compares the voltage at the second terminal with an upper threshold of a normal range and a lower threshold of the normal range, the processing device determining that there is a short-circuit on the wire when the voltage at the second terminal is below the lower threshold and the device determining that there is a cut in the wire when the voltage at the second terminal is above the upper threshold.

8. A system according to any of the claims 2 to 7, **characterized in that** the processing device comprises an interface for the acquisition of values of electrical properties of the wire and a memory capable of storing the acquired values of electrical properties.

9. A system according to any of the claims 4 to 8, **characterized in that** the fencing wire forms a double loop.

10. A system according to claim 9, **characterized in that** the double loop is closed.

11. A system according to claim 9 or 10, **characterized in that** the strands of the fencing wire extend in opposite directions from each end.

12. A group of systems according to any of the claims 4 to 8, **characterized in that** each system has at least two other capacitors connected to another fencing wire in a way similar to said first and second capacitors, a pack in which the measuring device and the respective processing device of each system are contained, the packs being attached to each other.

13. A monitoring system comprising:

- the group of claim 12; and
- a control device (8) communicating with the processing device of each system of the group to detect and report the type of malfunction communicated as the case may be for each processing device.

**Patentansprüche**

1. System zum Erkennen von Fehlern (1) in einem Elektrozaun, umfassend:

- einen Kondensator (C1) mit einer ersten Anschlussklemme (BC11) und einer zweiten Anschlussklemme (BC12), über die der Kondensator in Reihe mit einem Zaunleitungsdraht (31) anschließbar ist,
- einen Generator (42), der an eine der Anschlussklemmen des Kondensators in vorbestimmten Intervallen Hochspannungsimpulse anlegt, wobei die Impulse dazu geeignet sind, einen elektrischen Schlag auf eine den Draht berührende Person zu erzeugen,
- einen Generator (41) für Sinussignale zum Erkennen von Fehlern, der diese Sinussignale an die erste Anschlussklemme (BC11) des Kondensators zumindest teilweise während des Intervalls zwischen den Impulsen anlegt,
- eine Messvorrichtung, welche die Spannungen an den Anschlussklemmen des Kondensators (C1) während des Anlegens der Sinussignale misst,
- eine Verarbeitungsvorrichtung (6) für die gemessenen Spannungen, die ermittelt, ob ein eventueller Fehler ein Kurzschluss bzw. eine Unterbrechung an dem angeschlossenen Draht ist, und dann den Abstand zwischen dem Kondensator (C1) und dem Fehler ermittelt.

2. System nach Anspruch 1, **dadurch gekennzeichnet, dass** es einen Zaunleitungsdraht (31) umfasst, der zwischen seinen beiden Enden von der Erde isoliert ist und von dem ein erstes Ende an die zweite Anschlussklemme des Kondensators (BC12) angeschlossen ist.

3. System nach Anspruch 2, **dadurch gekennzeichnet, dass** es einen dritten Kondensator (CE) umfasst, der zwischen dem zweiten Drahtende und der Erde angeschlossen ist.

4. System nach Anspruch 2, **dadurch gekennzeichnet, dass**

- es ferner einen zweiten Kondensator (C2) umfasst, der in der Nähe des anderen Kondensators angeordnet ist und eine erste Anschlussklemme (BC21) aufweist, die an die erste Anschlussklemme des anderen Kondensators (C1) angeschlossen ist, sowie eine zweite Anschlussklemme, die an das zweite Ende des Leitungsdrahts angeschlossen ist,
- der Draht sich in zumindest zwei Strängen (311, 312) erstreckt, die im wesentlichen parallel verlaufen.

5. System nach Anspruch 4, **dadurch gekennzeichnet, dass** die Messvorrichtung (6) die Spannung der zweiten Anschlussklemme des zweiten Kondensators misst und dass die Verarbeitungsvorrichtung die Art von Fehler und den Abstand zwischen den Kondensatoren und dem Fehler ausgehend von den ermittelten Spannungen der zweiten Anschlussklemmen ermittelt.

6. System nach Anspruch 4 oder 5, **dadurch gekennzeichnet, dass** es einen dritten Kondensator (CE) umfasst, der zwischen der Leitungsdrahtmitte und der Erde angeschlossen ist.

7. System nach einem der vorangehenden Ansprüche, **dadurch gekennzeichnet, dass** die Verarbeitungsvorrichtung die Spannung an der zweiten Anschlussklemme mit einem oberen Schwellwert eines Normalbereichs und mit einem unteren Schwellwert des Normalbereichs vergleicht, wobei die Verarbeitungsvorrichtung einen Kurzschluss im Draht ermittelt, wenn die Spannung an der zweiten Anschlussklemme unter dem unteren Schwellwert liegt und die Vorrichtung eine Unterbrechung am Draht ermittelt, wenn die Spannung an der zweiten Anschlussklemme über dem oberen Schwellwert liegt.

8. System nach einem der Ansprüche 2 bis 7, **dadurch gekennzeichnet, dass** die Verarbeitungsvorrichtung eine Schnittstelle zum Erfassen der elektrischen Eigenschaften des Drahts und einen Speicher umfasst, welcher die erfassten elektrischen Eigenschaften speichern kann.

9. System nach einem der Ansprüche 4 bis 8, **dadurch gekennzeichnet, dass** der Zaundraht eine Doppelschleife bildet.

10. System nach Anspruch 9, **dadurch gekennzeichnet, dass** die Doppelschleife geschlossen ist.

11. System nach Anspruch 9 oder 10, **dadurch gekennzeichnet, dass** die Stränge des Zaundrahts sich von jedem Ende in entgegengesetzten Richtungen erstrecken.

12. Gruppenanordnung von Systemen nach einem der Ansprüche 4 bis 8, **dadurch gekennzeichnet, dass** jedes System zumindest zwei weitere Kondensatoren aufweist, die an einen weiteren Zaundraht in ähnlicher Art und Weise wie der erste und der zweite Kondensator angeschlossen sind, sowie ein Gehäuse, in welchem die Messvorrichtung und die jeweilige Verarbeitungsvorrichtung eines jeden Systems mit eingeschlossen sind, ferner **dadurch gekennzeichnet, dass** die Gehäuse zusammengefügt sind.

13. Überwachungssystem, umfassend:

- die Gruppenanordnung nach Anspruch 12, und
- eine Kontrollvorrichtung (8), die mit der Verarbeitungsvorrichtung eines jeden Systems der Gruppenanordnung kommuniziert, um die Art von Fehler zu erkennen und zu melden, der gegebenenfalls von jeder Verarbeitungsvorrichtung mitgeteilt wird.

**Fig. 1**

**Fig. 2**

**Fig. 3**

**Fig. 4**